Europäisches Patentamt

European Patent Office

Office européen des brevets

(11) Veröffentlichungsnummer : **0 130 490**
**B1**

(12) **EUROPÄISCHE PATENTSCHRIFT**

(45) Veröffentlichungstag der Patentschrift :
01.10.86

(21) Anmeldenummer : 84107126.9

(22) Anmeldetag : 20.06.84

(51) Int. Cl.⁴ : **G 01 R 33/035**

(54) Supraleitendes Gradiometerspulensystem für eine Vorrichtung zur mehrkanaligen Messung schwacher, sich ändernder Magnetfelder.

(30) Priorität : 05.07.83 DE 3324208

(43) Veröffentlichungstag der Anmeldung :
09.01.85 Patentblatt 85/02

(45) Bekanntmachung des Hinweises auf die Patenterteilung : 01.10.86 Patentblatt 86/40

(84) Benannte Vertragsstaaten :
DE FR GB

(56) Entgegenhaltungen :
US-A- 4 280 095

(73) Patentinhaber : Siemens Aktiengesellschaft Berlin
und München
Wittelsbacherplatz 2
D-8000 München 2 (DE)

(72) Erfinder : Hoenig, Eckhardt, Dr.
Palmstrasse 1a
D-8520 Erlangen (DE)

## Beschreibung

Die Erfindung bezieht sich auf ein supraleitendes Gradiometerspulensystem für eine Vorrichtung zur mehrkanaligen Messung schwacher, sich ändernder Magnetfelder in einem Feldstärkebereich unter $10^{-10}$ T, insbesondere unter $10^{-12}$ T, welche Vorrichtung in jedem Kanal neben mindestens einer Detektionsspule und mindestens einer Kompensationsspule, die zusammen eine Gradiometerspule bilden, ein supraleitendes Quanten-Interferenz-Element (SQUID) sowie entsprechende supraleitende Verknüpfungsglieder zwischen diesen Bauteilen enthält und welche ferner elektronische Einrichtungen zur Auswertung, Verarbeitung und Darstellung der an den Quanten-Interferenz-Elementen gewonnenen Informationen umfaßt.

Die Verwendung von supraleitenden Quanten-Interferenz-Elementen, die allgemein als « SQUIDs » (Abkürzung von « Superconducting Quantum Interference Devices ») bezeichnet werden, zur Messung sehr schwacher magnetischer Felder ist allgemein bekannt (J. Phys. E : Sci. Instrum., Vol. 13, 1980, Seiten 801 bis 813 ; « IEEE Transactions on Electron Devices », Vol. ED-27, No. 10, Oktober 1980, Seiten 1896 bis 1908). Als ein bevorzugtes Abwendungsgebiet für diese Elemente wird deshalb auch die medizinische Technik, insbesondere die Magnetokardiographie und Magnetoenzephalographie angesehen, wobei magnetische Herz- und Gehirnwellen mit Feldstärken in der Größenordnung von 50 pT bzw. 0,1 pT auftreten (« Biomagnetism — Proceedings Third International Workshop on Biomagnetism, Berlin 1980 », Berlin/New York 1981, Seiten 3 bis 31 oder « Review of Scientific Instruments », Vol. 53, No. 12, Dez. 1982, Seiten 1815 bis 1845).

Eine Vorrichtung zur Messung derartiger biomagnetischer Felder enthält im wesentlichen folgende Komponenten :

1. Ein SQUID als den eigentlichen Feld-Sensor mit einem sogenannten Gradiometer,

2. einen Flußtransformator in Form einer Spulenanordnung zur Einkopplung des zu untersuchenden Feldes,

3. elektronische Geräte zur Signalerfassung und -verarbeitung,

4. Abschirmungen für das magnetische Erdfeld und externe Störfelder und

5. ein Kryosystem zur Gewährleistung der Supraleitung von Sensor und Gradiometer.

Der Aufbau und die Funktionsweise entsprechender einkanalig ausgebildeter Vorrichtungen ist bekannt. Bei diesen Vorrichtungen wird das nachzuweisende Magnetfeld, das bis zu 6 Größenordnungen kleiner als externe Störfelder ist, im allgemeinen über eine Spulenanordnung aus supraleitendem Draht in den von einem Radiofrequenz (RF)-SQUID gebildeten Kreis mit einem Josephson-Kontakt induktiv eingekoppelt. Dabei sind durch Kombination einer Sensorspule — auch Detektionsspule genannt —

mit einer oder mehreren Kompensationsspulen als Gradiometer erster bzw. höherer Ordnung bezeichnete Spulensysteme ausgebildet. Mit solchen Gradiometern können bei entsprechendem manuellen Abgleich die drei Komponenten eines im Spulenbereich homogenen Magnetfeldes bzw. auch dessen Anteil mit homogenem Gradienten weitgehend unterdrückt und das im Gradiometerbereich noch stark inhomogene biomagnetische Nahfeld selektiv erfaßt werden. Das RF-SQUID ist außerdem mit einem Resonanzschwingkreis induktiv gekoppelt, dessen hochfrequente Spannung in Phase oder Amplitude durch das Eingangssignal moduliert wird. Im allgemeinen wird durch negative Rückkopplung über eine zusätzliche Kompensationsspule der Arbeitspunkt des RF-SQUID festgehalten und der Kompensationsstrom als elektronisch auszuwertendes Signal verwendet.

Aus den oben genannten Dokumenten ist es ferner an sich bekannt, Gradiometerspulen in Form von Dünnfilm-Spulenfeldern vorzusehen.

Die in diesen Anlagen eingesetzten RF-SQUIDs weisen ein charakteristisches Rausch-Signal auf (vgl. z. B. « SQUID-Superconducting Quantum Interferenz Devices and their Applications », Berlin/New York 1977, Seiten 395 bis 431). Zur Ermittlung der genannten, extrem schwachen Magnetfelder muß an den einzelnen Meßpunkten eine Signalmittelwertbildung durch eine Vielzahl von Einzelmessungen aus wenigstens den folgenden drei Gründen vorgenommen werden, nämlich wegen der unvollkommenen Störfeldunterdrückung, wegen Störanteilen im Nahfeld biologischen Ursprungs und wegen des Eigenrauschens des Sensors. Um eine räumliche Feldverteilung zu erhalten, muß außerdem zeitlich nacheinander an verschiedenen Orten des zu untersuchenden Bereiches gemessen werden. Bei diesen Meßverfahren besteht dann die Schwierigkeit, daß über die hierfür erforderliche Meßzeit die Kohärenz der Felddaten nicht mehr gegeben ist und sich außerdem klinisch unzumutbare Meßzeiten ergeben.

Es ist deshalb vorgeschlagen worden, statt der bekannten einkanaligen Messung eine mehrkanalige vorzunehmen (vgl. z. B. « Physica », Vol. 107B, 1981, Seiten 29 und 30 ; dieses Dokument belegt den Oberbegriff von Anspruch 1). Die gegenseitige Störung der Kanäle bei benachbarter Anordnung sowie das Eigenrauschen der Einzelkanäle kann durch die Verwendung von Gleichstrom (DC)-SQUIDs and Stelle von RF-SQUIDs reduziert werden (vgl. z. B. « IEEE Transactions on Magnetics », Vol. MAG-19, No. 3, Mai 1983, Seiten 835 bis 844). Der Abgleich der Einzelkanäle eines entsprechenden, modular aufgebauten Vielkanal-Gradiometer-Systems ist jedoch schwer zu beherrschen.

Aufgabe der vorliegenden Erfindung ist es, für eine mehrkanalige Vorrichtung zur Messung biomagnetischer Felder ein Gradiometerspulensystem zu schaffen, das einen verhältnismäßig einfachen und nur einmalig durchzuführenden Abgleich aller Gradiometerspulen erlaubt. Dabei soll die aktive Fläche des Spulensystems möglichst klein zu halten sein, um so den erforderlichen, entsprechend klein auszuführenden Kryostaten an den zu untersuchenden Probanden möglichst nach heranführen zu können. Außerdem soll mit diesem Spulensystem die räumliche Verteilung der Magnetfelder während zumutbarer Meßzeiten ermittelt werden können, wobei eine weitgehende Kohärenz der Felddaten gewährleistet ist.

Diese Aufgabe wird erfindungsgemäß für das eingangs genannte Gradiometerspulensystem dadurch gelöst, daß zumindest die Gradiometerspulen und ihre gegenseitigen Verknüpfungsglieder als planare Dünnfilmstrukturen in einer oder mehreren Ebenen auf einem gemeinsamen starren Trägerkörper aufgebracht sind, wobei die Kompensationsspulen zu einer Referenzspulenanordnung zusammengefaßt sind, um welche die einzelnen Detektionsspulen angeordnet sind.

Mit diesem so ausgestalteten Gradiometerspulensystem ist bei einem Einsatz in einer entsprechenden Meßvorrichtung eine parallele, d. h. gleichzeitige Registrierung der Feldwerte von verschiedenen Orten aus mit Hilfe einer Reihe von supraleitenden Gradiometerspulen ermöglicht, die mit einer entsprechenden Anzahl von SQUIDs zu einem Meßsystem verknüpft sind. Hiermit läßt sich vorteilhaft die Meßzeit entsprechend der Anzahl der Kanäle reduzieren. Außerdem müssen die Gradiometerspulen bei einem erfindungsgemäßen Aufbau unter Verwendung von Dünnfilmstrukturen nur einmalig abgeglichen werden. Dabei ist mit einer guten optischen Lithographie ein Gradiometerabgleich auf 10 ppm möglich, der nachträglich, z. B. mit Hilfe eines Laser-Schneidegerätes, noch weiter verbessert werden kann. Da ferner die Kompensationsspulen zu einer Referenzspulenanordnung zusammengezogen sind, die kaum mehr Platz als eine einzelne Detektionsspule benötigt, ergibt sich der große Vorteil, daß fast die gesamte Fläche des Trägerkörpers zur Signaldetektion mit Detektionsspulen belegt werden kann. Der Platzbedarf des Gradiometerspulensystem und somit die Abmessungen des Trägerkörpers sind dementsprechend klein zu halten. Dies bringt eine entsprechende Vereinfachung des Kryostaten mit sich.

Außerdem können die sogenannten Isofeldkonturen und darausfolgend die Lage von Feldquellen mit diesem Gradiometerspulensystem so gewonnen werden, als ob die Flächen des Trägerkörpers in eine der Anzahl der Kanäle entsprechende Zahl diskreter Magnetometerspulen aufgeteilt wäre, also mit dem besonderen Vorteil, daß mit dem erfindungsgemäßen System nur Felddifferenzen und keine Felder gemessen werden unter weitgehender Kompensation von Störfeldern.

Vorteilhafte Ausgestaltungen des Gradiometerspulensystems gehen aus den Unteransprüchen hervor.

Zur weiteren Erläuterung der Erfindung und deren in den Unteransprüchen gekennzeichneten Ausgestaltungen wird nachfolgend auf die Zeichnung Bezug genommen, in deren Figur 1 ein Schaltungsschema einer Meßvorrichtung mit einem Gradiometerspulensystem nach der Erfindung angedeutet ist. Figur 2 zeigt schematisch eine Ausbildungsmöglichkeit eines solchen Gradiometerspulensystems, während in Figur 3 die Referenzspulenanordnung dieses Systems schematisch näher veranschaulicht ist.

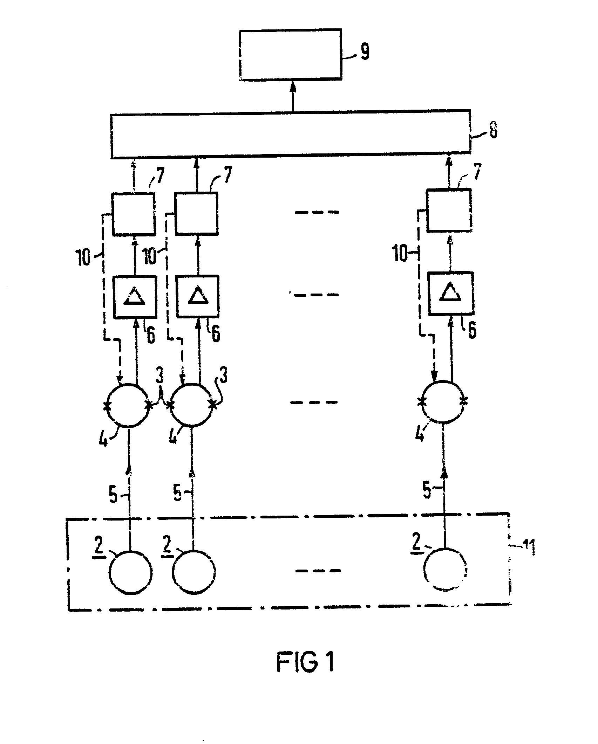

Gemäß dem in Figur 1 angedeuteten Schaltungsschema einer Meßvorrichtung ist eine vorbestimmte Anzahl N paralleler Meßkanäle vorgesehen. Jeder Kanal enthält dabei ein allgemein mit 2 bezeichnetes supraleitendes Gradiometer erster Ordnung mit jeweils zwei zur Detektion bzw. Kompensation dienenden Spulen und ein mit zwei Josephson-Kontakten 3 ausgestattetes DC-SQUID 4. Außerdem sind in jedem Kanal ein supraleitendes Verknüpfungsglied 5 zur Verbindung des Gradiometers mit dem SQUID, ferner ein beispielsweise ebenfalls gekühlter Vorverstärker 6 sowie ein sogenannter « Lock-in »-Verstärker 7 vorgesehen. Die aus diesen Lock-in-Verstärkern entnommenen N Rohsignale werden einem gemeinsamen elektronischen Datenverarbeitungs- und Steuerungssystem 8 zur Weiterverarbeitung und einer Ausgabeeinheit 9 zur Darstellung zugeführt. Eine Rückkopplung in den Kanälen an die jeweiligen SQUIDs mit den den Lock-in-Verstärkern 7 entnommenen Signalen ist durch eine gepunktete Linie 10 angedeutet. Die Signalübertragungsrichtungen sind in der Figur durch Pfeile an den entsprechenden Linien veranschaulicht.

Wie in Figur 1 ferner durch gestrichelte Linien dargestellt ist, sollen gemäß der Erfindung zumindest die Gradiometer 2 auf einem gemeinsamen, starren Trägerkörper 11 angeordnet sein. Gegenüber modular aufgebauten Gradiometern erster Ordnung ergibt sich hierdurch der Vorteil einer gemeinsamen präzisen Fertigung auf dem Trägerkörper durch eine geeignete Lithographie. Die abgeglichenen Gradiometer sind somit auf einem starren Körper vereinigt, d. h. Relativbewegungen, die den Abgleich beeinflussen könnten, sind deshalb ausgeschlossen. Außerdem ist bei einem optisch planen Trägerkörper auch nur ein einziger Flächenabgleich erforderlich.

Gegebenenfalls können auch Trägerkörper vorgesehen werden, auf die bei geeigneter Lithographie neben den Gradiometerspulen noch die Gesamtheit der SQUIDs 4 sowie die zwischen ihnen erforderlichen Verknüpfungsglieder 5 aufgebracht sind. Besondere supraleitende Kontakte sind dann nicht erforderlich.

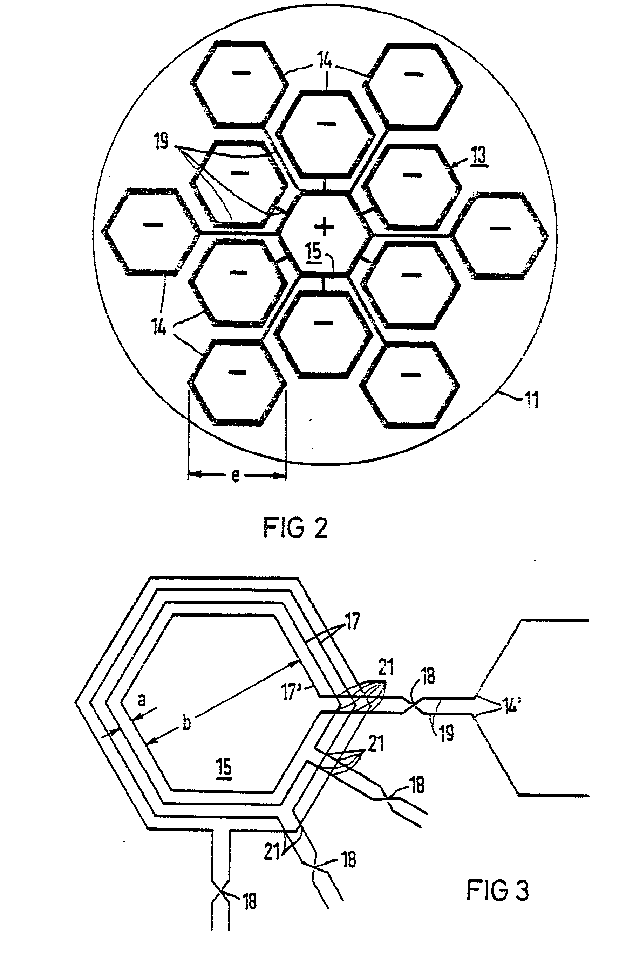

Die einfachste Anordnung von Feldsensoren ist ein System von Gradiometer nullter Ordnung, d. h. eine ebene Ordnung nebeneinanderliegender flacher Zylinderspulen bzw. -schleifen aus supraleitendem Draht oder in Form dünner Schichten. Für Messungen mit einem solchen System ohne zusätzliche Kompensation von Fremdfeldern ist jedoch eine verhältnismäßig aufwendige Abschirmung erforderlich. Geringere Anforderungen hinsichtlich der Abschirmung stellen Gradiometer erster Ordnung, wobei eine erfindungsgemäße Ausführungsform in den Figuren 2 und 3 angedeutet ist.

Gemäß Figur 2 ist auf einem ebenen Trägerkörper 11, beispielsweise einer Quarz- oder Siliziumscheibe von etwa 0,5 mm Dicke und 10 cm Durchmesser, ein planares Gradiometerspulen-System — auch Gradiometerfeld (Array) genannt — aufgebracht. Dieses mit 13 bezeichnete System wird durch eine Reihe von N, gemäß dem gewählten Ausführungsbeispiel von 12 Detektionsspulen 14 gebildet, die um eine zentrale Referenzspulenanordnung 15 herum angeordnet sind. Diese Referenzspulenanordnung besteht dabei aus einer entsprechenden Anzahl von Kompensationsspulen und ist in Figur 3 näher ausgeführt. Gemäß dem dargestellten Ausführungsbeispiel haben die Detektionsspulen 14 und die Referenzspulenanordnung 15 Sechseckform, wobei die Entfernung e gegenüberliegender Eckpunkte des Sechsecks im allgemeinen von dem Abstand der zu detektierenden Quelle abhängt. Diese Entfernung kann somit in der Größenordnung von einigen Zentimetern liegen und beträgt beispielsweise ungefähr 2 mm. Für die Spulen können jedoch auch andere, insbesondere regelmäßige Formen wie z. B. runde vorgesehen werden. Die einzelnen Spulen haben untereinander geringfügig verschiedene Abmessungen. Die Breite ihrer Leiter sowie diese Unterschiede liegen im Mikrometer-Bereich. Auf eine zeichnerische Darstellung der erforderlichen Zuleitungen zu den SQUIDs wurde in der Figur verzichtet. Wie jedoch ferner durch ein « + »- und « — »-Zeichen angedeutet sein soll, haben die Detektionsspulen 14 entgegengesetzten Wickelsinn wie die Spulen der Referenzspulenanordnung 15.

Die Gradiometerspulen werden auf dem Trägerkörper 11 in einem an sich bekannten Planarlithographie-Schritt in Form von supraleitenden Dünnfilm-Spulenfeldern beispielsweise aus Blei realisiert. Bei diesem Verfahrensschritt können auch die erforderlichen, in der Figur durch Linien 19 angedeuteten Verbindungsleitungen der einzelnen Spulen untereinander sowie deren Überkreuzungspunkte als Dünnfilm-Strukturen hergestellt werden.

In Figur 3 ist die Referenzspulenanordnung 15 gemäß Figur 2 vergrößert dargestellt, wobei gleiche Teile mit den gleichen Bezugszeichen versehen sind. Aus dieser Figur ist ersichtlich, daß sich diese Spulenanordnung aus N einzelnen, sich quasi konzentrisch umschließenden Teilschleifen zusammensetzt. Der Abstand a zwischen benachbarten Teilschleifen kann z. B. etwa 4 μm betragen. Jede dieser Teilschleifen, die beispielsweise aus einem etwa 0,5 μm dicken und 2 μm breiten supraleitenden Streifen gebildet werden, stellt eine Kompensationsspule zu einer besonderen Detektionsspule 14 dar, wobei jede Teilschleife mit ihrer zugeordneten Kompensationsspule flächengleich ist. Daraus folgt, daß die Detektionsspulen 14 alle untereinander geringfügig verschiedene Größe haben. Der Abstand b zwischen parallelen Seiten der innersten, mit 17' bezeichneten Teilschleife der Referenzspulenanordnung 15 beträgt dabei z. B. etwa 20 mm. In der Figur ist ferner nur die zu der innersten Teilschleife 17' zugeordnete Detektionsspule 14' teilweise ausgeführt. Für die N Gradiometer erster Ordnung des Spulensystems nach der Erfindung sind N gleichartige Kreuzungen 18 in den Verbindungsleitungen 19 zwischen jeder Kompensationsspulenschleife 17 und ihrer zugeordneten Detektionsspule 14 erforderlich. Außerdem ergeben sich noch N — 1 verschiedenartige Kreuzungen 21 zwischen den Kompensationsspulenschleifen 17 und den Verbindungsleitungen 19. Entsprechende Kreuzungen können beispielsweise mit einer Lithographie hergestellt werden, bei der zwei Metallisierungsebenen vorgesehen sind, zwischen denen eine Isolatorebene liegt. In Figur 3 wurde auf eine zeichnerische Darstellung der Anschlußleitungen der SQUIDs verzichtet.

Nach dem Aufbau des Gradiometerspulen-Systems auf dem Trägerkörper 11 wird ein einmaliger Abgleich der Spulen vorgenommen. Hierzu kann insbesondere ein Laserstrahl verwendet werden, mit dem die Breite der einzelnen Spulenwindungen zu verringern ist.

Mit dem erfindungsgemäßen Gradiometerspulen-System können die zu ermittelnden Linien gleicher magnetischer Feldstärke, die sogenannten Isofeldkonturen (vgl. den genannten Artikel aus « Review of Scientific Instruments ») auf verhältnismäßig einfache Weise aus den gemessenen Signalwerten erhalten werden. Mit jedem der N planaren Gradiometer erster Ordnung ist ein Signalwert zu messen, der als Differenzfeldwert interpretiert wird. Dieser Signalwert ist $\phi_i - \bar{\phi}_i$ mit $1 \leq i \leq N$, wobei $\phi_i$ die magnetische Flußänderung in der iten Detektionsspule 14 und $\bar{\phi}_i$ die zugehörende Flußänderung in der entsprechenden Kompensationsspule 17 der Referenzspulenanordnung sind. Diese Signalwerte können z. B. der Mitte der iten Detektionsspule räumlich zugeordnet werden. Durch geeignete überlappende Messung läßt sich der von dem Gradiometerspulen-System erfaßte Bereich erweitern. Durch Interpolation werden dann Isofeldkonturen berechnet, die einen additiven, nur von der Zeit abhängigen Summanden enthalten. Dies ist jedoch zur Ermittlung von Quellenort und Quellenrichtung unerheblich. Die weniger wichtige Quellenstärke bleibt dabei unbekannt. Sie kann aber mit einem axialen 1-Kanalgerät zusätzlich gemessen werden.

Auch Gradiometersysteme höherer Ordnung lassen sich mit dem Gradiometerspulen-System nach der Erfindung ohne weiteres realisieren. Z. B. für ein System zweiter Ordnung brauchen nämlich nur zwei des in den Figuren 2 und 3 gezeigten Gradiometerspulen-Systems in axialer Richtung übereinander angeordnet zu werden. Dabei ist eine Serienschaltung entsprechender Gradiometer i beider Systeme bei entgegengesetztem Wickelsinn vorzusehen. Die Teile eines solchen Systems zweiter Ordnung bestehen also aus voll abgeglichenen Gradiometern erster Ordnung, die lediglich planparallel zueinander ausgerichtet werden müssen. Gradiometersysteme noch höherer Ordnung lassen sich entsprechend aufbauen.

### Patentansprüche

1. Supraleitendes Gradiometerspulensystem für eine Vorrichtung zur mehrkanaligen Messung schwacher, sich ändernder Magnetfelder in einem Feldstärkebereich unter $10^{-10}$ T, insbesondere unter $10^{-12}$ T, welche Vorrichtung in jedem Kanal neben mindestens einer Detektionsspule (14) und mindestens einer Kompensationsspule (15), die zusammen eine Gradiometerspulebilden, ein supraleitendes Quanten-Interferenz-Element (SQUID) sowie entsprechende supraleitende Verknüpfungsglieder (19) zwischen diesen Bauteilen enthält und welche ferner elektronische Einrichtungen zur Auswertung, Verarbeitung und Darstellung der an den Quanten-Interferenz-Elementen gewonnenen Informationen umfaßt, dadurch gekennzeichnet, daß zumindest die Gradiometerspulen (14, 15, 17) und ihre gegenseitigen Verknüpfungsglieder (Verbindungsleitungen 19) als planare Dünnfilmstrukturen in einer oder mehreren Ebenen auf einem gemeinsamen starren Trägerkörper (11) aufgebracht sind, wobei die Kompensationsspulen zu einer Referenzspulenanordnung (15) zusammengefaßt sind, um welche die einzelnen Detektionsspulen (14) angeordnet sind.

2. Gradiometerspulensystem nach Anspruch 1, dadurch gekennzeichnet, daß die Kompensationsspulen (17) der Referenzspulenanordnung (15) zumindest teilweise aus einzelnen sich umschließenden, in einer Ebene liegenden Schleifen gebildet sind.

3. Gradiometerspulensystem nach Anspruch 2, dadurch gekennzeichnet, daß die Detektionsspulen (14) und ihre zugeordneten Kompensationsspulen (17) jeweils flächengleich sind.

4. Gradiometerspulensystem nach einem der Ansprüche 1 bis 3, dadurch gekennzeichnet, daß die Gradiometerspulen (14, 17) eine sechseckige, runde oder eine andere regelmäßige Gestalt haben.

5. Gradiometerspulensystem nach einem der Ansprüche 1 bis 4, dadurch gekennzeichnet, daß sein Trägerkörper (11) auch zur Aufnahme der Quanten-Interferenz-Elemente (4) sowie der Verknüpfungsglieder (5) zwischen diesen Elementen (4) und den Gradiometerspulen (14, 17) vorgesehen ist.

6. Gradiometerspulensystem nach einem der Ansprüche 1 bis 5, dadurch gekennzeichnet, daß ein Trägerkörper (11) zumindest größtenteils aus Quarz oder Silizium besteht.

7. Gradiometerspulensystem zweiter oder höherer Ordnung nach einem der Ansprüche 1 bis 6, gekennzeichnet durch eine der Ordnungszahl entsprechende Anzahl von Trägerkörpern mit jeweils einem Gradiometerspulensystem erster Ordnung, wobei die Gradiometerspulensysteme in planparallelen Ebenen zueinander angeordnet sind und entsprechende Spulen in benachbarten Ebenen verschiedenen Wicklungssinn haben.

8. Gradiometerspulensystem nach einem der Ansprüche 1 bis 6, dadurch gekennzeichnet, daß den Gradiometerspulenpaaren (14, 17) jeweils ein Gleichstrom-Quanten-Interferenz-Element (DC-SQUID) zugeordnet ist.

### Claims

1. A super-conductive gradiometer coil system for a device for the multichannel testing of weak alternating magnetic fields in a field strength range below $10^{-10}$ T, in particular below $10^{-12}$ T, in which device each channel comprises in addition to at least one detection coil (14) and at least one compensation coil (15), together forming a gradiometer coil, and a super-conductive quantum interference element (SQUID) with corresponding super-conductive linking elements (19) between the components, and which device further comprises electronic devices for analysing, processing and representing the informations obtained by the quantum interference elements, characterised in that at least the gradiometer coils (14, 15, 17) and their mutual linking elements (connecting elements 19) are applied on a common rigid carrier body (11) as planar thin-film structures in one or more planes, where the compensation coils are combined to form a reference coil arrangement (15), around which the individual detection coils (14) are arranged.

2. A gradiometer coil system as claimed in Claim 1, characterised in that the compensation coils (17) of the reference coil arrangement (15) are at least partially formed from individual loops which enclose one another and are arranged in one plane.

3. A gradiometer coil system as claimed in Claim 2, characterised in that the respective detection coils (14) and their assigned compensation coils (17) are of equal area.

4. A gradiometer coil system as claimed in one of Claims 1 to 3, characterised in that the gradiometer coils (14, 17) have a hexagonal, round or other regular shape.

5. A gradiometer coil system as claimed in one of Claims 1 to 4, characterised in that its carrier body (11) is provided for accommodating the quantum interference elements (4) and the linking elements (5) between said elements (4) and the gradiometer coils (14, 17).

6. A gradiometer coil system as claimed in one of Claims 1 to 5, characterised in that a carrier body (11) consists at least predominately of quartz or silicon.

7. A gradiometer coil system of second or higher order as claimed in one of Claims 1 to 6, characterised by a number of carrier bodies which corresponds to the ordinal index, where the carrier bodies respectively have a gradiometer coil system of the first order and where the gradiometer coil systems are arranged in plane-parallel planes relative to one another and where corresponding coils in adjacent planes have a different sense of winding.

8. A gradiometer coil system as claimed in one of Claims 1 to 6, characterised in that the gradiometer coil pairs (14, 17) are respectively assigned a direct current quantum interference element (DC-SQUID).

## Revendications

1. Système supraconducteur de bobines de gradiomètres pour un dispositif servant à réaliser la mesure, suivant des canaux multiples, de faibles champs magnétiques variables dans une gamme d'intensités de champ inférieure à $10^{-10}$ T, et notamment inférieure à $10^{-12}$ T, lequel dispositif contient dans chaque canal, en plus d'au moins une bobine de détection (14) et d'au moins une bobine de compensation (15), qui forment ensemble une bobine de gradiomètre, un dispositif interférentiel quantique supraconducteur (SQUID) ainsi qu'un organe supraconducteur correspondant de liaison (19) entre ces composants, et comporte en outre des dispositifs électroniques servant à évaluer, traiter et représenter des informations obtenues au niveau des dispositifs interférentiels quantiques, caractérisé par le fait qu'au moins les bobines (14, 15, 17) de gradiomètres et leurs organes de liaison mutuels (lignes de liaison 19) sont déposés sous la forme de structures planes à couches minces dans un ou plusieurs plans sur un support rigide commun (11), les bobines de compensation étant réunies de manière à former un ensemble (15) de bobines de référence, autour duquel les différentes bobines de détection (14) sont disposées.

2. Système de bobines de gradiomètres suivant la revendication 1, caractérisé par le fait que les bobines de compensation (17) de l'ensemble (15) de bobines de référence sont formées au moins en partie par des boucles individuelles qui s'enveloppent mutuellement et sont situées dans un plan.

3. Système de bobines de gradiomètres suivant la revendication 2, caractérisé par le fait que les bobines de détection (14) et les bobines de compensation (17), qui leur sont associées, possèdent des surfaces respectives identiques.

4. Système de bobines de gradiomètres suivant l'une des revendications 1 à 3, caractérisé par le fait que les bobines (14, 17) du gradiomètre possèdent une configuration hexagonale, une configuration circulaire ou une autre configuration régulière.

5. Système de bobines de gradiomètres suivant l'une des revendications 1 à 4, caractérisé par le fait que son support (11) est également prévu pour recevoir les dispositifs interférentiels quantiques (4) ainsi que les organes de liaison (5) entre ces dispositifs (4) et les bobines (14, 17) des gradiomètres.

6. Système de bobines de gradiomètres suivant l'une des revendications 1 à 5, caractérisé par le fait qu'un support (11) est constitué au moins en majeure partie par du quartz ou par du silicium.

7. Système de bobines de gradiomètres du second ordre ou d'ordre supérieur suivant l'une des revendications 1 à 6, caractérisé par un nombre, correspondant au numéro d'ordre de supports possédant respectivement un système de bobines de gradiomètres du premier ordre, les systèmes de bobines des gradiomètres étant disposés dans des plans parallèles entre eux, et des bobines correspondantes dans des plans voisins possèdent des sens de bobinage différents.

8. Système de bobines de gradiomètres suivant l'une des revendications 1 à 6, caractérisé par le fait que des dispositifs interférentiels quantiques à courant continu (DC-SQUID) respectifs sont associés aux couples (14, 17) de bobines des gradiomètres.

FIG 1

1

FIG 2

FIG 3

2